# EUROPÄISCHE PATENTSCHRIFT

(11) **EP 1 204 149 B1**
(45) Veröffentlichungstag und Bekanntmachung des Hinweises auf die Patenterteilung: **27.06.2007**
(21) Anmeldenummer: 01125838.1
(22) Anmeldetag: 30.10.2001
(51) Int. Cl.: H01L 31/18, C23C 14/08

(54) **Verfahren zur Deposition von Schichtsystemen und deren Verwendung**
Method of multilayer deposition and its use
Méthode de déposition d'un système de couches et son utilisation

(30) Priorität: 30.10.2000 DE 10053844
(43) Veröffentlichungstag der Anmeldung: 08.05.2002
(73) Patentinhaber: Fraunhofer-Gesellschaft zur Förderung der angewandten Forschung e.V., 80686 München (DE)
(72) Erfinder: Szyszka, Bernd, 38108 Braunschweig (DE); Höing, Thomas, 38106 Braunschweig (DE)
(74) Vertreter: Pfenning, Meinig & Partner GbR

(56) Entgegenhaltungen:
- EP-A- 0 677 593
- EP-A- 0 915 523
- YANG T L ET AL: "Transparent conducting ZnO:Al films deposited on organic substrates deposited by r.f. magnetron-sputtering" THIN SOLID FILMS, ELSEVIER-SEQUOIA S.A. LAUSANNE, CH, Bd. 326, Nr. 1-2, 4. August 1998 (1998-08-04), Seiten 60-62, XP004141461 ISSN: 0040-6090
- ELLMER K ET AL: "INFLUENCE OF DISCHARGE PARAMETERS ON THE LAYER PROPERTIES OF REACTIVE MAGNETRON SPUTTERED ZNO:AL FILMS" THIN SOLID FILMS, ELSEVIER-SEQUOIA S.A. LAUSANNE, CH, Bd. 247, Nr. 1, 1. Juli 1994 (1994-07-01), Seiten 15-23, XP000454896 ISSN: 0040-6090
- SZYSZKA B: "Transparent and conductive aluminum doped zinc oxide films prepared by mid-frequency reactive magnetron sputtering" THIN SOLID FILMS, ELSEVIER-SEQUOIA S.A. LAUSANNE, CH, Bd. 351, Nr. 1-2, 30. August 1999 (1999-08-30), Seiten 164-169, XP004183086 ISSN: 0040-6090
- LIPPENS, P., VERHEYEN, P.: "Electrochromic Half-Cells on Organic Substrate Produced by Subsequent Deposition of ITO and WO3 in a Roll Coater Using Optical Plasma Emision Monitoring" PROC. 37TH ANN. TECH. CONF. SOC. VACUUM COATERS, Mai 1994 (1994-05), Seiten 254-260, XP008038063 BOSTON, USA
- SZCZYRBOWSKI, J., BRÄUER, G., RUSKE, M. , BARTELLA, J. , SCHROEDER, J., ZMELTY, A.: "Some properties of TiO2 layers prepared by medium frequency reactive sputtering" SURFACE AND COATINGS TECHNOLOGY, Bd. 112, Nr. 1-3, Februar 1999 (1999-02), Seiten 261-266, XP008038014 ELSEVIER, SWITZERLAND

## Beschreibung

Die Erfindung betrifft ein Verfahren zur Deposition eines optisch transparenten und elektrisch leitfähigen Schichtsystems auf einem Substrat. Mit Hilfe dieses Verfahrens ist es auch möglich, polymere Substrate bei sehr geringen Subtrattemperaturen zu beschichten. Verwendung findet das Verfahren bei der Herstellung von wärmereflektierenden Beschichtungen verschiedenster Substrate, wie z.B. Flachbildschirmen, Solarzellen oder anderen optoelektronischen Bauteilen.

Transparente und leitfähige Schichtsysteme sind Schlüsselkomponenten für Produkte wie Flachbildschirme, Solarzellen und andere optoelektronische Komponenten. Aufgrund ihrer metallischen Leitfähigkeit weisen derartige Schichtsysteme zudem ein hohes Reflexionsvermögen im infraroten Spektralbereich und damit spektral selektive optische Eigenschaften auf. Sie eignen sich als wärmereflektierende Beschichtung, um so z.B. den Energieeintrag in einem verglasten Raum aufgrund der Erwärmung durch das Sonnenlicht zu optimieren.

Für derartige Funktionsschichten sind bisher zwei Arten von Schichtsystemen etabliert: transparente und leitfähige Oxide wie In₂O₃:Sn, SnO₂:Sb, SnO₂:F und ZnO:Al, die auf der hochentarteten n-Dotierung von Halbleitern mit großer Bandlücke basieren, sowie Isolator-Metall-Isolator-Schichtsysteme, die auf der Entspiegelung dünner und somit nur wenig absorbierender Metallschichten beruhen.

Isolator-Metall-Isolator-Schichtsysteme können bei guter Qualität auf ungeheizten Substraten abgeschieden werden, während für hochwertige TCO-Schichtsysteme im allgemeinen Substrattemperaturen oberhalb von 200°C benötigt werden. Isolator-Metall-Isolator-Schichtsysteme sind jedoch mechanisch und chemisch sehr empfindlich. Überdies ist die Kontaktierung der leitfähigen Schicht durch die dielektrische Entspiegelung hindurch sehr problematisch, so daß die chemisch und mechanisch sehr resistenten TCO-Schichtsysteme in vielen Fällen unabdingbar sind.

TCO-Schichtsysteme wurden bisher primär durch PVD-, aber auch durch CVD-Beschichtungsprozesse abgeschieden. Als Substratmaterial kamen vorwiegend unterschiedliche Glassubstrate wie Natrium-Kalkglas (konventionelles Floatglas, Grünglas) oder Borsilikatglas zum Einsatz, so daß ein Aufheizen der Substrate auf Temperaturen im Bereich von 200 bis 300°C im allgemeinen problemlos durchgeführt werden konnte.

Die aktuellen Entwicklungen zeigen jedoch, daß Polymere wie Polymethylmetacrylat (PMMA) als Substratmaterial zunehmend technische Bedeutung gewinnen. Gerade die TCO-Beschichtung dieser Werkstoffe ist kritisch, da die bisher erforderlichen hohen Substrattemperaturen bei diesen Materialien die Zerstörung des Substrates nach sich ziehen.

Aus dem Stand der Technik sind verschiedene Ansätze zur Lösung der oben genannten Aufgabenstellung bekannt, die primär auf die etablierten ITO-Schichtsysteme abzielen. Dieses Material weist einen Phasenübergang amorph-kristallin bei ca. 170°C auf. Ansatzpunkt ist zum einen die Optimierung amorpher ITO-Schichtsysteme bei niedriger Substrattemperatur. Zum anderen besteht die Möglichkeit, durch ein zusätzliches lonenbombardement der aufwachsenden Schicht den Übergang amorph-kristallin zu geringeren Temperaturen zu verschieben. Dies ist Gegenstand des etablierten Leybold APS Verfahrens zur Niedertemperatur-Deposition von ITO-Schichtsystemen.

Das Dokument EP-A-0 915 523 offenbart ein Verfahren zur Deposition eines optisch transparenten und elektrisch leitfähigen Zinkoxid-Schichtsystems auf einem polymeren Substrat durch ein DC-Sputterverfahren bei einer Substrattemperatur zwischen 10 und weniger als 200 °C. Es offenbart aber kein Mittelfrequenz-Magnetronsputternverfahren im instabilen Bereich.

Das Dokument SZCZYRBOWSKI ET AL. in SURFACE AND COATINGS TECHNOLOGY, Bd. 112, Nr. 1-3, Februar 1999, Seiten 261-266, offenbart ein Mittelfrequenz-Magnetronsputternverfahren im instabilen Bereich für ein Titanoxidschichtsystem auf Glas.

Ausgehend hiervon war es Aufgabe der vorliegenden Erfindung, optisch transparente und elektrisch leitfähige Schichtsysteme mit einem geringen Defektstrukturanteil bereitzustellen, die eine breite Anwendung ermöglichen.

Diese Aufgabe wird durch das gattungsgemäße Verfahren mit den kennzeichnenden Merkmalen des Anspruchs 1 gelöst. Die weiteren abhängigen Ansprüche zeigen vorteilhafte Weiterbildungen auf. Die Verwendung des Verfahrens wird gemäß den Ansprüchen 10 und 11 gekennzeichnet.

Überraschenderweise konnte gezeigt werden, daß trotz der gegenüber dem Stand der Technik wesentlich geringeren Substrattemperaturen deutlich defektärmere Schichten bereitgestellt werden konnten. Hierdurch eignet sich dieses Verfahren hervorragend für polymere Substrate, da diese nur in einem begrenzten Temperaturbereich beschichtbar sind.

Es wird ein Zinkoxid-Schichtsystem abgeschieden, das sowohl undotiert oder auch metallisch dotiert sein kann. Als Dotierelement wird dabei bevorzugt Aluminium verwendet.

Die Deposition erfolgt mit Hilfe von reaktivem Mittelfrequenz-Magnetronsputtern. Dabei werden die Parameter Entladungsleistung P und Partialdruck des Reaktivgases derart eingestellt, daß die Deposition im instabilen Bereich zwischen dem metallischen und dem oxidischen Bereich erfolgt. Der reaktive MF-Sputterprozeß weist gegenüber konventionellen Sputterverfahren eine erhöhte Ionenstromdichte am Substrat auf, so daß ein Verhältnis zwischen Ionenstrom und Metallstrom von etwa 1:10 erreicht wird. Konventionelle Sputterverfahren weisen dagegen ein Verhältnis Ionenstrom zu Metallstrom von 1:100 auf, während das in der Einleitung beschriebene Leybold-APS-Verfahren ein Verhältnis von etwa 1:1 aufweist. Diese Eigenheit des MF-Sputterprozesses trägt zur Verstärkung der Oberflächendiffusion und zur Plasmaaktivierung des reaktiven Prozesses bei.

Die Deposition kann dabei mit vergleichbar hohen Beschichtungsraten von mehr als 80 nm/min erfolgen.

Die Deposition kann bevorzugt bei einer Substrattemperatur zwischen 10 und 100°C, besonders bevorzugt bei RT, durchgeführt werden.

Als Substrate kommen beliebige Polymere in Frage. Bevorzugt werden Polymethylmethacrylat (PMMA) oder Polycarbonat (PC) verwendet.

Das erfindungsgemäße Verfahren weist den Vorteil auf, daß hiermit nun auch großflächige Substrate, z. B. Flachbildschirme, beschichtet werden können. Hierdurch werden neue Anwendungsfelder für die Beschichtung mit optisch transparenten und elektrisch leitfähigen Schichten ermöglicht.

Verfahrenstechnisch wird als Reaktivgas beim MF-Sputterprozeß bevorzugt, Sauerstoff und als weiteres Prozeßgas bevorzugt ein Edelgas, z.B. Argon verwendet.

Die Steuerung des Prozesses hat eine wesentliche Bedeutung dafür, daß die entstehenden Schichten einen geringen Anteil an Defektstrukturen aufweisen. Hierfür ist es bevorzugt, daß im metallischen Modus die Plasmaleistung so lange reduziert wird, bis ein signifikanter Anstieg des Reaktivgaspartialdruckes zu beobachten ist. Anschließend wird dann die Plasmaleistung in der Weise erhöht, daß die Deposition des Schichtsystems im instabilen Bereich durchgeführt werden kann. Damit die Beschichtung im instabilen Bereich durchgeführt werden kann, muß das Verfahren während der Beschichtung durch Steuerung der Verfahrensparameter in diesem Bereich gehalten werden. Dies erfolgt durch die Abstimmung der Entladungsleistung P und des Partialdruckes des Reaktivgases derart, daß der Übergang in den metallischen und oxidischen Bereich verhindert wird.

Es wird ebenso ein beschichtetes Substrat bereitgestellt, daß nach dem erfindungsgemäßen Verfahren erhältlich ist, aber nicht zu dieser Erfindung gehört. Dieses weist überraschenderweise im Vergleich zum Stand der Technik deutlich geringere Anteile an Defektstrukturen auf.

Bevorzugt besteht das Schichtsystem dabei aus Zinkoxid, das in hexagonaler Wurzit-Struktur vorliegt. Das hexagonale Wurzit ermöglicht dabei aufgrund der polaren Eigenschaften die Ausbildung einer polykristallinen Mikrostruktur in der Schicht.

Diese polykristalline Mikrostruktur weist dabei bevorzugt eine Korngröße zwischen 30 und 120 nm auf.

Vorzugsweise weist das Schichtungssystem eine Ladungsträgerdichte von ne > 8x10²⁰ cm⁻³ auf.

Das erfindungsgemäße Verfahren findet bevorzugt Verwendung für die Herstellung von mit Wärme reflektierenden Beschichtungen versehenen Substraten. Hierzu zählen beispielsweise Flachbildschirme, Solarzellen und/oder andere optoelektronische Bauteile.

Anhand des folgenden Beispiels und der folgenden Figuren soll der erfindungsgemäße Gegenstand näher erläutert werden, ohne diesen auf diese Ausführungsform zu beschränken.

Fig. 1 zeigt den schematischen Aufbau der In-LineSputteranlage Leybold A700V.

Fig. 2 zeigt in einem Diagramm die Abhängigkeit des Reaktivgaspartialdruckes p_{O2} von der Entladungsleistung P für leistungsgeregelte Prozeßführung bei konstantem Gasfluß (q_{Ar} = 2x100 sccm, p_{Ar} = 360 mPa, q_{O2} = 4x25 sccm).

Fig. 3 zeigt Transmissionsspektren von ZnO:Al-Schichten, die im instabilen Übergangsbereich bei p_{O2}=33 mPa auf der in Fig. 1 dargestellten Kennlinie bei einer Depositionsrate von mehr als 80 nm/min abgeschieden wurden.

Fig. 4 zeigt XRD-Spektren von ZnO-Proben, die bei unterschiedlicher Substrattemperatur durch reaktives MF-Magnetronsputtern im instabilen Bereich auf Quarzglas aufgetragen wurden.

### Beispiel 1:

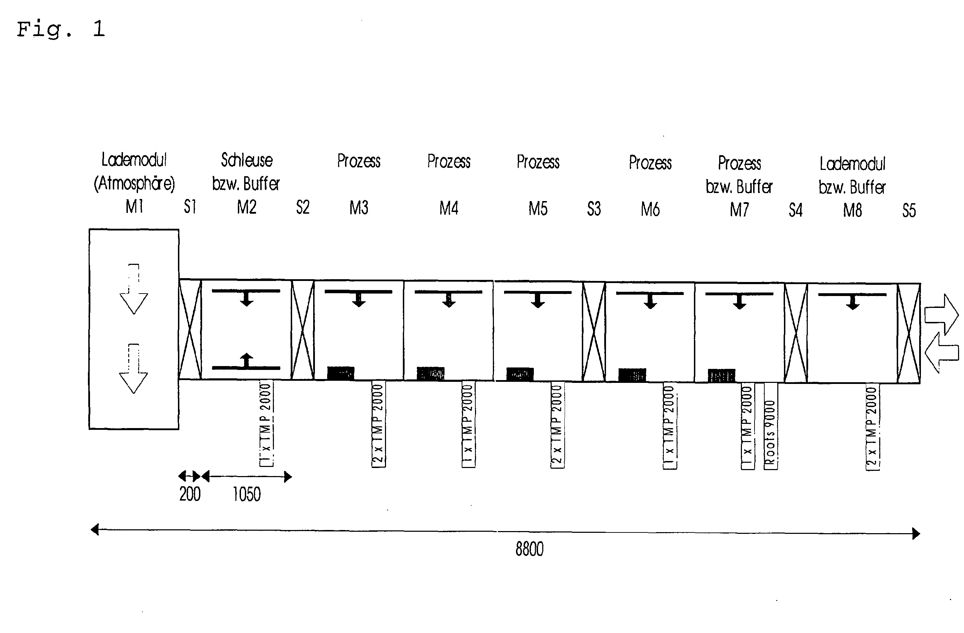

Untersucht wurde das reaktive MF-Magnetronsputtern von ZnO:Al-Schichtsystemen mit einer In-Line-Sputteranlage. Das Schema der Beschichtungsanlage ist in Fig. 1 dargestellt.

Die verwendete Sputteranlage enthält Doppelkathoden-Sputterquellen (Leybold TwinMag^{™}), die auf zwei konventionellen Magnetron-Kathoden Leybold PK 750 basieren (Targetformat 748 x 88 mm²) aufnimmt. Sputtergas und Reaktivgas werden über unabhängige Gasverteiler getrennt über konventionelle Massenflußregler (Fa. MKS) zugegeben. Die Entladungsleistung des Generators kann über einen Steuerrechner, der auch der Datenerfassung der Entladungsparameter dient, eingestellt werden.

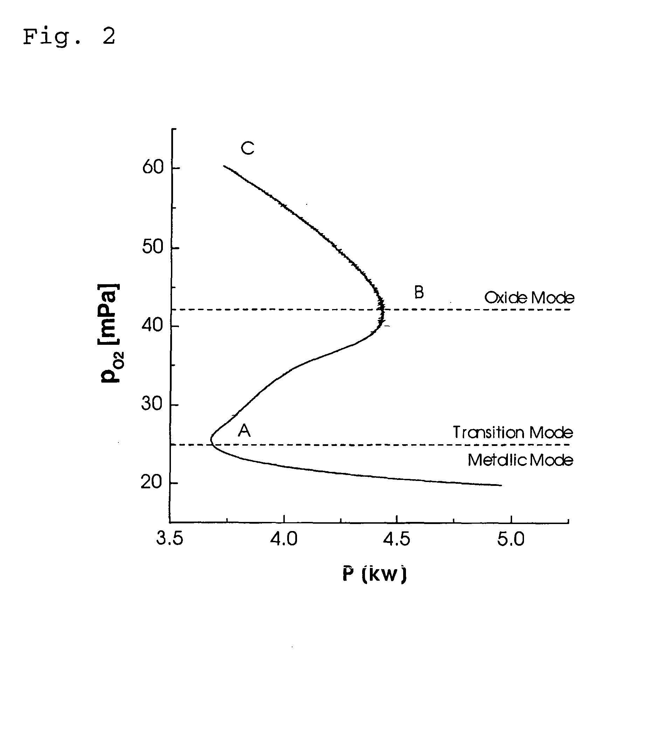

Fig. 2 zeigt die Abhängigkeit des Reaktivgaspartialdrucks pₐ₂ von der Entladungsleistung P bei Verwendung der oben beschriebenen Prozeßregelung und den in Tab. 1 beschriebenen Anlagen- und Prozeßparametern.

Zunächst wird der Prozeß bei einer Entladungsleistung von P = 5 kW im Metallic Mode betrieben. In diesem Zustand ist die Targetoberfläche nur geringfügig durch Metalloxide bedeckt, so daß im Vergleich zur oxidierten Targetoberfläche im Oxide Mode eine hohe Metall-Teilchenstromdichte emittiert wird. Das gesputterte Metall reagiert am Substrat und an den Kammerwänden mit dem eingelassenen Sauerstoff. Aufgrund dieser Getterwirkung folgt im Metallic Mode ein geringer Reaktivgaspartialdruck von p_{O2}≈20 mPa.

Beim Absenken der Entladungsleistung kommt es am Punkt A zum abrupten Ansteigen des Reaktivpartialdrucks. Diese, für reaktive Sputterprozesse charakteristische Instabilität resultiert aus der einsetzenden Oxidation des Targets. Es kommt zur Abnahme der Metall-Teilchenstromdichte aufgrund der kleineren Sputterausbeute der oxidierten Targetbereiche, was das Gettern des Reaktivgases beeinträchtigt. Insgesamt wird beim Überschreiten eines kritischen Reaktivgaspartialdrucks ein selbstverstärkender Prozeß angestoßen, der ohne das Eingreifen einer Prozeßregelung den unstetigen Übergang vom Arbeitspunkt A zum Arbeitspunkt C im Oxide Mode zur Folge hat.

Mit Hilfe des oben skizzierten Regelkreises wird die Entladungsleistung beim Erreichen des Punktes A erhöht. Auf diese Weise wird das Umkippen des Prozesses in den Oxide Mode verhindert. Es gelingt, den Prozeß im gesamten instabilen Bereich (Transition Mode) entlang der Kennlinie AB vom Metallic Mode in den Oxide Mode zu überführen.

In der folgenden Tabelle sind die Standard-Prozeßbedingungen für die hier vorgestellten Untersuchungen aufgeführt.

| Prozeß | RMFMS, harmonische Anregung TwinMag^{™} auf PK 750-Basis | | |
|---|---|---|---|
| Anlagenparameter | Deposition in Modul M3 | | |
| | Saugvermögen Vakuum-Pumpsystem: | S_{rMP} | M3:100% sonst: 0% |
| | Target-Substrat-Abstand | d₅₇ | 90 mm |
| | Al-Gehalt des Zn:Al-Targets: | c^{T}_{AL} | 2,0 Gew.-% |
| | Reinheit des Target-materials: | | 99,99 % |
| | Ar-Fluß: | q | 2x100 sccm |
| | O₂-Fluß: | q_{O2} | 4x25 sccm |
| | Gasreinheit: | | 4.8 |
| | Heiztemperatur: | T | RT - 250°C |
| | dynamische Beschichtung | v_{c} | 1 mm s⁻¹ |
| Prozeßparameter | Entladungsleistung: | P | ≈ 4 kW |
| | Leistungsdichte: | P/A | ≈ 3 W cm⁻² |
| | Reaktivgaspartialdruck: | pₒ₇ | 30 - 40 mPa |
| | Ar-Partialdruck: | P_{Ar} | 190-360 mPa |
| | Prozeßregelung: | | P = f (pₒ₇) |
| Substrat-material | 1 x Borsilikatglas-substrat (AF 45) | | 50 x 50 x 1,1 mm³ |
| | 1 x Standard-PC (Al 2647) | | 40 x 60 x 4 mm³ |
| | 1 x Hochtemperatur-PC (HAT 9371) | | 40 x 60 x 4 mm³ |

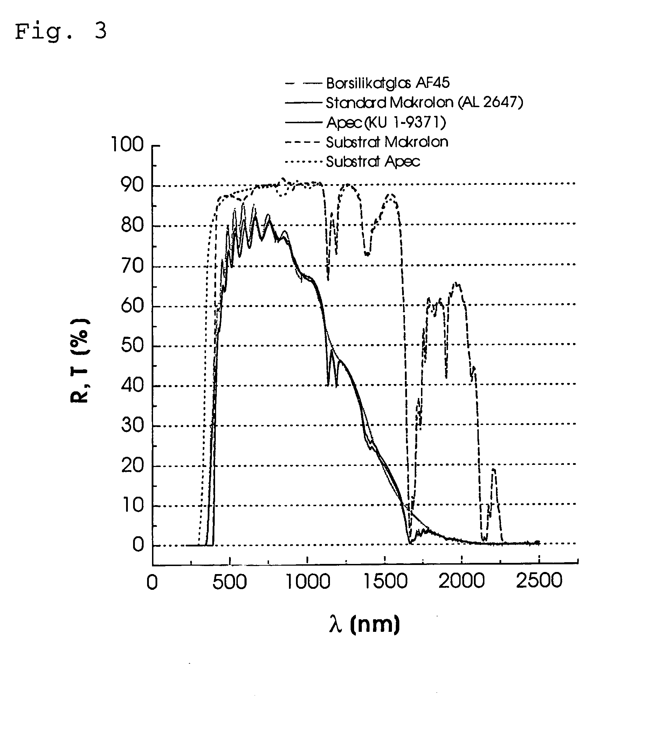

Fig. 3 zeigt die Transmissionsspektren von ZnO:Al-Proben, die im instabilen Übergangsbereich bei einem Reaktivgaspartialdruck von P_{O2} ≈ 33 mPa auf Glas und Polymersubstraten abgeschieden wurden. Mit einem Schichtwiderstand von Rₛₕ= 6,9 Ω entsprechend einem spezifischen Widerstand von 910 µΩcm bei der auf Glas abgeschiedenen Probe kann so ein spektral selektives Verhalten erreicht werden, welches z.B. aufgrund der geringen Transmission im NIR zum verminderten Aufheizen von Polycarbonat verglasten Fahrzeuginnenräumen führt.

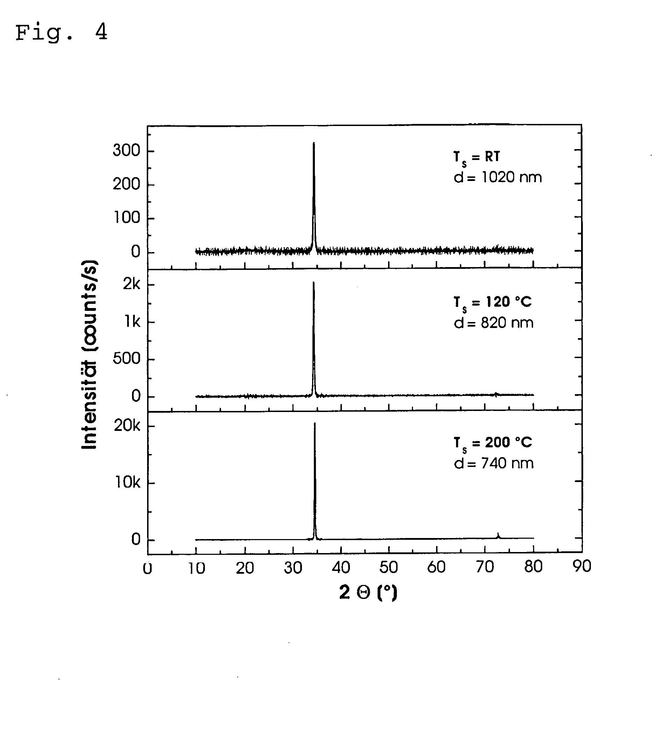

Spektren von XRD-Untersuchungen an ZnO-Proben, die bei unterschiedlicher Substrattemperatur durch reaktives MF Magnetronsputtern im Transition Mode hergestellt wurden, sind in Fig. 4 dargestellt.

Bereits bei ungeheizten Substraten konnten polykristalline, in (002)-Orientierung texturierte Schichten abgeschieden werden. Die aus der Halbwertsbreite des (002)-Reflexes bestimmte Korngröße beträgt dabei 32 nm. Bei Übergang auf 200°C Substrattemperatur unter sonst gleichen Depositionsbedingungen wird die Korngröße dabei auf 120 nm erhöht.

## Patentansprüche

1. Verfahren zur Deposition eines optisch transparenten und elektrisch leitfähigen, undotierten oder metallisch dotierten Zinkoxid-Schichtsystems auf einem polymeren Substrat bei einer Substrattemperatur zwischen 10 und weniger als 200 °C durch reaktives Mittelfrequenz-Magnetron-sputtern, wobei die Parameter Entladungsleistung P und Partialdruck des Reaktivgases so eingestellt werden, dass die Deposition im instabilen Bereich zwischen metallischem und oxidischem Bereich und einer Beschichtungsrate von mehr als 80 nm/min erfolgt.

2. Verfahren nach Anspruch 1,
**dadurch gekennzeichnet, dass** als Dotierelement Aluminium verwendet wird.

3. Verfahren nach mindestens einem der vorhergehenden Ansprüche,
**dadurch gekennzeichnet, dass** die Deposition bei einer Substrattemperatur zwischen 10 und 100 °C, bevorzugt bei RT durchgeführt wird.

4. Verfahren nach mindestens einem der vorhergehenden Ansprüche,
**dadurch gekennzeichnet, dass** als Substrat Polymethylmethacrylat (PMMA) verwendet wird.

5. Verfahren nach mindestens einem der vorhergehenden Ansprüche,
**dadurch gekennzeichnet, dass** als Substrat Polycarbonat (PC) verwendet wird.

6. Verfahren nach mindestens einem der vorhergehenden Ansprüche,
**dadurch gekennzeichnet, dass** ein großflächiges Substrat, z.B. ein Flachbildschirm, verwendet wird.

7. Verfahren nach mindestens einem der vorhergehenden Ansprüche,
**dadurch gekennzeichnet, dass** als Reaktivgas Sauerstoff und als weiteres Prozessgas ein Edelgas, z.B. Argon, verwendet werden.

8. Verfahren nach mindestens einem der vorhergehenden Ansprüche,
**dadurch gekennzeichnet, dass** im metallischen Modus die Plasmaleistung solange reduziert wird bis ein signifikanter Anstieg des Reaktivgaspartialdrucks zu beobachten ist und anschließend die Plasmaleistung derart erhöht wird, dass die Deposition im instabilen Bereich durchführbar ist.

9. Verfahren nach mindestens einem der vorhergehenden Ansprüche,
**dadurch gekennzeichnet, dass** nach Erreichen des instabilen Bereichs die Parameter Entladungsleistung P und Partialdruck des Reaktivgases so abgestimmt werden, dass ein Übergang in den metallischen und oxidischen Bereich verhindert wird.

10. Verwendung des Verfahrens nach mindestens einem der Ansprüche 1 bis 9 zur Herstellung von mit wärmereflektierenden Beschichtungen versehenen Substraten.

11. Verwendung des Verfahrens nach mindestens einem der Ansprüche 1 bis 9 zur Beschichtung von Flachbildschirmen, Solarzellen und/oder anderen optoelektronischen Bauteilen.

## Claims

1. Method for the deposition of an optically transparent and electrically conductive undoped or metallically doped zinc oxide layer system on a polymer substrate at a substrate temperature of between 10 and less than 200°C by means of reactive medium frequency magnetron sputtering, whereby the parameter discharge capacity P and the partial pressure of the reactive gas are adjusted in such a way that the deposition occurs within the non-stable range between the metallic and the oxidic area at an acceleration rate of more than 80 nm/min.

2. Method according to Claim 1, **characterised in that** aluminium is used as the doping element.

3. Method according to at least one of the preceding Claims, **characterised in that** the deposition is carried out at a substrate temperature of between 10 and 100°C, preferably at room temperature.

4. Method according to at least one of the preceding Claims, **characterised in that** polymethylmethacrylate (PMMA) is used as a substrate.

5. Method according to at least one of the preceding Claims, **characterised in that** polycarbonate (PC) is used as a substrate.

6. Method according to at least one of the preceding Claims, **characterised in that** a large surface substrate, for example a flat monitor, is used.

7. Method according to at least one of the preceding Claims, **characterised in that** oxygen is used as a reactive gas, and a rare gas, for example argon, is used as a further process gas.

8. Method according to at least one of the preceding Claims, **characterised in that** the plasma capacity is reduced in the metallic mode until a significant increase of the reactive gas partial pressure is noticed, and **in that** the plasma capacity is subsequently increased in such a way that the deposition in the non-stable range is possible.

9. Method according to at least one of the preceding Claims, **characterised in that** the parameters discharge capacity P and the partial pressure of the reactive gas are selected in such a way once the non-stable range is reached that a transition into the metallic and oxidic areas is prevented.

10. Use of the method according to at least one of the Claims 1 to 9 for producing substrates equipped with heat reflecting coatings.

11. Use of the method according to at least one of the Claims 1 to 9 for coating flat monitors, solar cells and/or other optoelectronic components.

## Revendications

1. Procédé de dépôt d'un système stratifié d'oxyde de zinc optiquement transparent et électroconducteur, non dopé ou dopé par un métal, sur un substrat polymère à une température du substrat comprise entre 10 et moins de 200 °C, par pulvérisation réactive au magnétron à moyenne fréquence, dans lequel on règle les paramètres de puissance de décharge P et de pression partielle du gaz réactif de sorte que le dépôt ait lieu dans le domaine instable entre le domaine métallique et le domaine oxydé et à une vitesse de revêtement de plus de 80 nm/min.

2. Procédé selon la revendication 1,
**caractérisé en ce que** l'on utilise de l'aluminium comme élément de dopage.

3. Procédé selon au moins l'une quelconque des revendications précédentes,
**caractérisé en ce que** le dépôt est réalisé à une température du substrat comprise entre 10 et 100 °C, de préférence à température ambiante (TA).

4. Procédé selon au moins l'une quelconque des revendications précédentes,
**caractérisé en ce que** l'on utilise du poly(méthacrylate de méthyle) (PMMA) comme substrat.

5. Procédé selon au moins l'une quelconque des revendications précédentes,
**caractérisé en ce que** l'on utilise un polycarbonate (PC) comme substrat.

6. Procédé selon au moins l'une quelconque des revendications précédentes,
**caractérisé en ce que** l'on utilise un substrat de grande surface, par exemple, un écran plat.

7. Procédé selon au moins l'une quelconque des revendications précédentes,
**caractérisé en ce que** l'on utilise de l'oxygène comme gaz réactif et un gaz rare, par exemple l'argon, comme autre gaz du procédé.

8. Procédé selon au moins l'une quelconque des revendications précédentes,
**caractérisé en ce que** la puissance du plasma est réduite en mode métallique jusqu'à ce que l'on observe une augmentation notable de la pression partielle du gaz réactif et, ensuite, la puissance du plasma est augmentée de manière à pouvoir réaliser le dépôt dans le domaine instable.

9. Procédé selon au moins l'une quelconque des revendications précédentes,
**caractérisé en ce que**, dès lors que l'on atteint le domaine instable, on ajuste les paramètres de puissance de décharge P et de pression partielle du gaz réactif, pour empêcher une transition dans le domaine métallique et dans le domaine oxydé.

10. Utilisation du procédé selon au moins l'une quelconque des revendications 1 à 9, pour fabriquer des substrats pourvus de revêtements réfléchissant la chaleur.

11. Utilisation du procédé selon au moins l'une quelconque des revendications 1 à 9, pour recouvrir des écrans plats, des piles solaires et/ou d'autres composants optoélectroniques.
